# EUROPEAN PATENT SPECIFICATION

(11) **EP 3 416 277 B1**
(45) Date of publication and mention of the grant of the patent: **23.09.2020**
(21) Application number: 16914061.3
(22) Date of filing: 21.12.2016
(51) Int. Cl.: H02M 7/217, H02M 1/08, H03K 17/04, H03K 17/042, H03K 17/30

(54) **RECTIFIER DIODE REPLACEMENT CIRCUIT AND REVERSE BIAS CUT-OFF DRIVE CIRCUIT**
GLEICHRICHTERDIODENERSATZSCHALTUNG UND TREIBERSCHALTUNG MIT GEGENSPANNUNGSSTOPP
CIRCUIT DE REMPLACEMENT DE DIODE DE REDRESSEUR ET CIRCUIT DE COMMANDE DE COUPURE DE POLARISATION INVERSE

(30) Priority: 26.08.2016 CN 201610734419
(43) Date of publication of application: 19.12.2018
(73) Proprietor: Chongqing Southwest Integrated Circuit Design Co., Ltd, Chongqing 400060 (CN)
(72) Inventor: ZHANG, Zhenrong, Chongqing 400060 (CN); FAN, Lin, Chongqing 400060 (CN); WANG, Lu, Chongqing 400899 (CN); LIU, Yongguang, Chongqing 400060 (CN); YU, Jinchuan, Chongqing 400015 (CN); HE, Xudong, Chongqing 400000 (CN); WAN, Tiancai, Chongqing 400060 (CN); XU, Hua, Chongqing 400016 (CN)
(74) Representative: Lermer, Christoph
(86) International application number: PCT/CN2016/111191
(87) International publication number: WO 2018/036041

(56) References cited:
- CN-A- 102 904 421
- CN-A- 102 904 421
- CN-A- 104 953 859
- CN-Y- 200 976 577
- JP-A- H08 317 656
- JP-A- 2005 198 375
- US-A1- 2016 241 225

## Description

### Technical Field

The present invention relates to a rectifier diode, and more particularly to a rectifier diode replacement circuit and a reverse bias cut-off drive circuit.

### Background Art

A diode is a core device in a power supply system, and generally, a diode circuit of which the diode performance is improved by using a special semiconductor device or a power MOSFET and switch control circuit is used.

The special semiconductor device may form a PN junction silicon diode by using a method for growing a PN junction by P-type impurity diffusion and N-type impurity diffusion on a silicon substrate or may form a Schottky diode by using a method for forming a metal-silicon junction by using a processing technology for metal and silicon combination on a silicon surface. A forward voltage drop of the diode is limited by a material and a structure of a device, the forward voltage of the PN junction silicon diode is about 0.6V and the forward voltage of the Schottky diode is about 0.4V under the current of about 8A, and it is very difficult to reduce the forward voltages by technical regulation. However, the latest technology is to adopt a diode circuit which is a circuit achieving the characteristics of a diode by controlling the on and cut-off of an MOSFET by a control circuit.

Therefore, the special semiconductor device has the problem of high forward voltage, and the diode circuit has the problem of long reverse cut-off time. Although the high forward voltage of the semiconductor device may not be effectively dropped by technical improvement, the reverse cut-off time existing in the diode circuit may be shortened by means of the structure of the circuit. Document CN 102 904 421 A discloses a rectifier diode replacement circuit comprising a rectifier diode circuit.

Document US 2016/241225 A1 discloses an active diode circuit for letting current pass in one direction and blocking current in the opposite direction.

### Summary of the Invention

The technical problem to be solved by the present invention is to provide a rectifier diode replacement circuit.

In order to solve the technical problem, the present invention adopts the technical solution: a rectifier diode replacement circuit having reverse bias cut-off drive includes a rectifier diode circuit and a reverse bias cut-off drive circuit, and the rectifier diode circuit includes an energy storage capacitor, a low-voltage clock generator, a charge pump circuit, a bandgap reference circuit, a hysteresis comparator, a drive amplifier and a power MOS transistor; the low-voltage clock generator is connected with both ends of the rectifier diode circuit and adapted for detecting voltages at both ends of the rectifier diode circuit and generating a clock signal to drive the charge pump circuit; the charge pump circuit is connected with the low-voltage clock generator, the low-voltage clock generator, and the hysteresis comparator, and adapted for detecting voltages at both ends of the rectifier diode circuit, and adapted for storing charges into the energy storage capacitor after being amplified; the rectifier diode circuit is adapted for outputting voltages stored on the energy storage capacitor and a reference voltage output by the bandgap reference circuit, respectively, to the hysteresis comparator so as to be compared; the hysteresis comparator is connected with the drive amplifier, and adapted for outputting an on signal to be amplified by the drive amplifier, when the voltages stored on the energy storage capacitor are greater than the reference voltage output by the bandgap reference circuit; the amplifier is connected with the power MOS transistor and adapted for then outputing the amplified signal to the power MOS transistor to drive the power MOS transistor to be on; the reverse bias cut-off drive circuit is connected with both ends of the rectifier diode circuit, and adapted for detecting the voltages at both ends of the rectifier diode circuit, and for forming a charge discharge channel at a gate of the power MOS transistor to cut off the power MOS transistor, when a cathode potential is greater than an anode potential.

Alternatively, a rectifier diode replacement circuit has reverse bias cut-off drive, comprising a rectifier diode circuit and a reverse bias cut-off drive circuit; the rectifier diode circuit comprises an energy storage capacitor, a low-voltage clock generator, a charge pump circuit, a bandgap reference circuit, a hysteresis comparator, a drive amplifier and a power MOS transistor; the low-voltage clock generator is connected with both ends of the rectifier diode circuit and adapted for detecting voltages at both ends of the rectifier diode circuit and generating a clock signal to drive the charge pump circuit; the charge pump circuit is connected with the low-voltage clock generator, the low-voltage clock generator, and the hysteresis comparator, and adapted for detecting voltages at both ends of the rectifier diode circuit, and adapted for storing charges storage into the energy capacitor after being amplified; the rectifier diode circuit is adapted for outputting voltages stored on the energy storage capacitor and a reference voltage output by the bandgap reference circuit, respectively, to the hysteresis comparator so as to be compared; the hysteresis comparator is connected with the drive amplifier), and adapted for outputting an on signal to be amplified by the drive amplifier, when the voltaes stored on the energy storage capacitor are greater than the reference voltage output by the bandgap reference circuit; the amplifier is connected with the power MOS transistor and adapted for then outputing the amplified signal to the power MOS transistor to drive the power MOS transistor to be on; the reverse bias cut-off drive circuit is adapted for forming a charge discharge channel at both ends of the energy storage capacitor so that the energy storage capacitor discharges by means of the reverse bias cut-off drive circuit; and the hysteresis comparator is adapted for outputting an off signal to cut off the power MOS transistor, when the voltages at both ends of the energy storage capacitor are lower than an output voltage of the bandgap reference circuit in the rectifier diode circuit.

The rectifier diode circuit has two working states including a charge state and a discharge state when being forwards biased. During charge, the power MOS transistor is in a channel cut-off state, and the rectifier diode circuit may be rapidly cut off when being converted from a forward bias to a reverse bias. When the rectifier diode circuit is in the discharge state, the energy storage capacitor C is larger in value to achieve a low average forward on voltage, so that the discharge time is longer and reaches several tens of ms to several hundreds of ms. The invention solves the problems that the rectifier diode circuit may not be rapidly cut-off when the rectifier diode circuit is converted from the forward bias to the reverse bias in the discharge state, and the rectifier diode circuit may enter the reverse bias cut-off state only after the whole discharge period is finished; after the rectifier diode circuit is converted from the forward bias to the reverse bias, the cut-off time does not exceed 1 ms, meanwhile, the forward working performance of the rectifier diode circuit is not affected, and the advantage of original low average forward on voltage is still kept. According to a preferred solution of the rectifier diode replacement circuit having reverse bias cut-off drive, the reverse bias cut-off drive circuit includes a transfer switch transistor, a second hysteresis comparator and a discharge switch transistor, the discharge switch transistor is connected in parallel with the energy storage capacitor and is controlled to be on or off by the second hysteresis comparator, the transfer switch transistor is connected between the positive input end of the second hysteresis comparator and the cathode of the rectifier diode circuit or between the negative input end of the second hysteresis comparator and the anode of the rectifier diode circuit; the transfer switch transistor is controlled to be on or off by the rectifier diode circuit; and the second hysteresis comparator detects voltages at both ends of the rectifier diode circuit, when a cathode potential of the rectifier diode circuit is greater than an anode potential, the second hysteresis comparator controls the discharge switch transistor to be on so that the energy storage capacitor discharges by means of the discharge switch transistor; and when the voltages at both ends of the energy storage capacitor are lower than the output voltage of the bandgap reference circuit in the rectifier diode circuit, the rectifier diode circuit outputs a control signal to cut off the power MOS transistor.

According to the technical solution, the voltages (K, A) at both ends of the rectifier diode circuit are compared and monitored, when the rectifier diode circuit is converted from the forward bias to the reverse bias in the discharge state, the potential at the end K is greater than that at the end A, the second hysteresis comparator in the circuit provided by the present invention outputs a high level, and drives the discharge switch transistor to be on to form the rapid charge discharge channel at both ends of the energy storage capacitor, so that the rectifier diode circuit rapidly discharges charges accumulated by charging the capacitor in a charge period, and the voltages at both ends of the energy storage capacitor are rapidly dropped; and when the voltages at both ends of the energy storage capacitor are lower than a bandgap reference output voltage in the rectifier diode circuit, the voltage output by the hysteresis comparator becomes low, the output level of the drive amplifier becomes low, and the power MOS transistor is driven to be switched off, so that the rectifier diode circuit may be rapidly cut off. According to the technical solution of the present invention, the voltages at both ends of the diode circuit are actively detected in real time, when the diode circuit is converted from the forward bias to the reverse bias, a rapid discharge channel is generated at both ends of the energy storage capacitor to greatly shorten the discharge period and rapidly cut off the rectifier diode circuit, so that the aim of rapidly reversing the rectifier diode circuit when the rectifier diode circuit is reversely biased is achieved.

According to a preferred solution of the rectifier diode replacement circuit having reverse bias cut-off drive, provided by the present invention, the reverse bias cut-off drive circuit includes a transfer switch transistor, a second hysteresis comparator and a discharge switch transistor; the discharge switch transistor is connected in parallel between a gate of the power MOS transistor and a negative end of the energy storage capacitor and is controlled to be on or off by the second hysteresis comparator, and the transfer switch transistor is connected between the positive input end of the second hysteresis comparator and the cathode of the rectifier diode circuit or between the negative input end of the second hysteresis comparator and the anode of the rectifier diode circuit; the transfer switch transistor is controlled to be on or off by the rectifier diode circuit; the second hysteresis comparator detects voltages at both ends of the rectifier diode circuit, and when a cathode potential of the rectifier diode circuit is greater than an anode potential, the second hysteresis comparator controls the discharge switch transistor to be on to form a charge discharge channel at a gate of the power MOS transistor, so that the power MOS transistor is cut off.

Or when the rectifier diode circuit is converted from the forward bias to the reverse bias in the discharge state, the potential at the end K is greater than that at the end A, the second hysteresis comparator outputs the high level to drive the discharge switch transistor to be on to form a rapid charge discharge channel at a gate of the power MOS transistor, so that the power MOS transistor is cut off. The aim of rapidly reversing the rectifier diode circuit when the rectifier diode circuit is reversely biased is also achieved.

According to a technical solution of the rectifier diode replacement circuit having reverse bias cut-off drive, provided by the present invention, the transfer switch transistor and the discharge switch transistor are composed of MOSFETs; a gate of a first MOSFET is connected with an output of the drive amplifier, a source and drain of a second MOSFET are connected in parallel to both ends of the energy storage capacitor, and a gate of the second MOSFET is connected with an output of the second hysteresis comparator.

According to a preferred solution of the rectifier diode replacement circuit having reverse bias cut-off drive, provided by the present invention, the transfer switch transistor and the discharge switch transistor are composed of MOSFETs; and a gate of the first MOSFET is connected with an output of the drive amplifier, a source and drain of the second MOSFET are connected in parallel between a gate of the power MOS transistor and a negative end of the energy storage capacitor, and a gate of the second MOSFET is connected with an output of the second hysteresis comparator.

A reverse bias cut-off drive circuit of a rectifier diode replacement circuit used in connection with the invention is characterized by including a transfer switch transistor, a second hysteresis comparator and a discharge switch transistor; the discharge switch transistor is connected in parallel with the energy storage capacitor in the rectifier diode replacement circuit and is controlled to be on or off by the second hysteresis comparator; the transfer switch transistor is connected between the positive input end of the second hysteresis comparator and the cathode of the rectifier diode replacement circuit or between the negative input end of the second hysteresis comparator and the anode of the rectifier diode replacement circuit; and the second hysteresis comparator detects voltages at both ends of the rectifier diode replacement circuit, when a cathode potential of the rectifier diode replacement circuit is greater than an anode potential, the second hysteresis comparator controls the discharge switch transistor to be on so that the energy storage capacitor discharges by means of the discharge switch transistor; and when the voltages at both ends of the energy storage capacitor C are lower than an output voltage of the bandgap reference circuit in the rectifier diode replacement circuit, the rectifier diode replacement circuit outputs a control signal to cut off the power MOS transistor.

According to a preferred solution of the reverse bias cut-off drive circuit of the rectifier diode replacement circuit, provided by the present invention, the transfer switch transistor and the discharge switch transistor are composed of MOSFETs; and a gate of the transfer switch transistor is connected with an output of the drive amplifier, a source and drain of the discharge switch transistor are connected in parallel to both ends of the energy storage capacitor, and a gate of the discharge switch transistor is connected with an output of the second hysteresis comparator. According to a preferred solution of the reverse bias cut-off drive circuit of the rectifier diode replacement circuit, provided by the present invention, the reverse bias cut-off drive circuit includes a transfer switch transistor, a second hysteresis comparator and a discharge switch transistor; the discharge switch transistor is connected in parallel between the gate of the power MOS transistor and a negative end of the energy storage capacitor in the rectifier diode replacement circuit and is controlled to be on or off by the second hysteresis comparator; the transfer switch transistor is connected between the positive input end of the second hysteresis comparator and the cathode of the rectifier diode replacement circuit or between the negative input end of the second hysteresis comparator and the anode of the rectifier diode replacement circuit; and the second hysteresis comparator detects voltages at both ends of the rectifier diode replacement circuit, and when a cathode potential of the rectifier diode replacement circuit is greater than an anode potential, the second hysteresis comparator 7 controls the discharge switch transistor to be on to form a charge discharge channel at a gate of the power MOS transistor, so that the power MOS transistor is cut off.

According to a preferred solution of the reverse bias cut-off drive circuit of the rectifier diode replacement circuit, provided by the present invention, the transfer switch transistor and the discharge switch transistor are composed of MOSFETs; and a gate of the transfer switch transistor is connected with an output of the drive amplifier, a source and drain of the discharge switch transistor are connected in parallel between a gate of the power MOS transistor and a negative end of the energy storage capacitor, and a gate of the discharge switch transistor is connected with an output of the second hysteresis comparator.

The rectifier diode replacement circuits provided by the present invention have the beneficial effects that the problem that the rectifier diode circuit may not be rapidly cut off when being converted from the forward bias to the reverse bias in the discharge state is solved, after being converted from the forward bias to the reverse bias, the rectifier diode circuit may be rapidly cut off, meanwhile, the forward working performance of the rectifier diode circuit is not affected, the advantage of original low average forward on voltage is still kept, and the application prospect is good. The scope of the invention is defined in the appended claims. Any reference to "embodiment(s)", "example(s)" or "aspect(s) of the invention" in this description not falling under the scope of the claims should be interpreted as illustrative example(s) for understanding the invention.

### Brief Description of the Drawings

Fig. 1 is a functional block diagram of a rectifier diode replacement circuit in an Embodiment 1.
Fig. 2 is a functional block diagram of a rectifier diode replacement circuit in an Embodiment 2.
Fig. 3 is a functional block diagram of a reverse bias cut-off drive circuit.
Fig. 4 is an equivalent circuit diagram of a rectifier diode replacement circuit.

### Detailed Description of the Invention

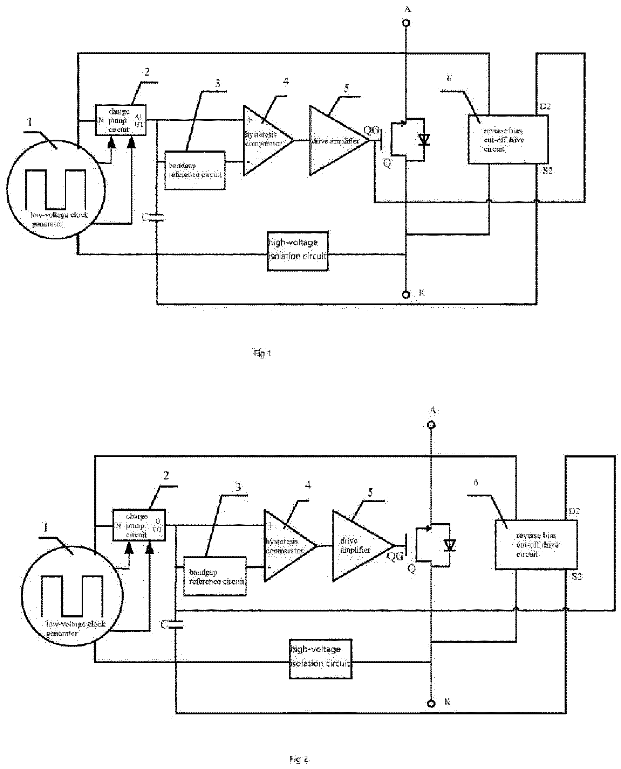

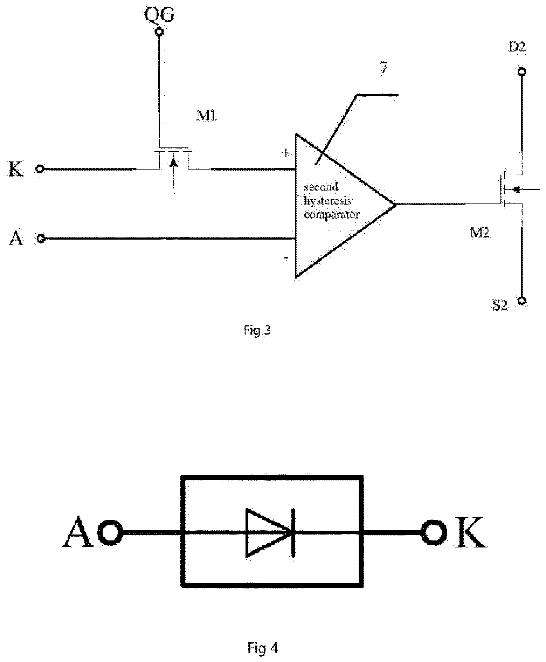

In an Embodiment 1, referring to Fig. 1, Fig. 3 and Fig. 4, a rectifier diode replacement circuit having reverse bias cut-off drive includes a rectifier diode circuit and a reverse bias cut-off drive circuit 6; the rectifier diode circuit includes an energy storage capacitor C, a low-voltage clock generator 1, a charge pump circuit 2, a bandgap reference circuit 3, a hysteresis comparator 4, a drive amplifier 5 and a power MOS transistor Q;
the low-voltage clock generator 1 detects voltages at both ends A and K of the rectifier diode circuit and generates a clock signal to drive the charge pump circuit 2;
the charge pump circuit 2 detects voltages at both ends A and K of the rectifier diode circuit, and charges are stored into the energy storage capacitor C after being amplified;
voltages stored on the energy storage capacitor C and a reference voltage output by the bandgap reference circuit 3 are respectively output to the hysteresis comparator 4 so as to be compared; when the voltages stored on the energy storage capacitor 4 are greater than the reference voltage output by the bandgap reference circuit 3, the hysteresis comparator 4 outputs an on signal to be amplified by the drive amplifier 5 and then output to the power MOS transistor Q to drive the power MOS transistor Q to be on;
the reverse bias cut-off drive circuit 6 detects the voltages at both ends A and K of the rectifier diode circuit, and when a cathode potential is greater than an anode potential,
the reverse bias cut-off drive circuit 6 forms a rapid charge discharge channel at a gate of the power MOS transistor Q to cut off the power MOS transistor Q.

In the detailed embodiment, the reverse bias cut-off drive circuit 6 includes a transfer switch transistor M1, a second hysteresis comparator 7 and a discharge switch transistor M2; the discharge switch transistor M2 is connected in parallel between the gate of the power MOS transistor Q and a negative end of the energy storage capacitor C and is controlled to be on or off by the second hysteresis comparator 7; the transfer switch transistor M1 is connected between the positive input end of the second hysteresis comparator 7 and the cathode of the rectifier diode circuit or between the negative input end of the second hysteresis comparator 7 and the anode of the rectifier diode circuit; the transfer switch transistor M1 is controlled to be on or off by the rectifier diode circuit; and the second hysteresis comparator 7 detects voltages at both ends A and K of the rectifier diode circuit, and when a cathode potential of the rectifier diode circuit is greater than an anode potential, the second hysteresis comparator 7 controls the discharge switch transistor M2 to be on to form a charge discharge channel at the gate of the power MOS transistor Q, so that the power MOS transistor Q is cut off.

Further, the transfer switch transistor M1 and the discharge switch transistor M2 are composed of MOSFETs; and a gate of the transfer switch transistor M1 is connected with an output of the drive amplifier 5, a source and drain of the discharge switch transistor M2 are connected in parallel between a gate of the power MOS transistor Q and a negative end of the energy storage capacitor C, and a gate of the discharge switch transistor M2 is connected with an output of the second hysteresis comparator 7.

In an Embodiment 2, referring to Fig. 2, Fig. 3 and Fig. 4, a rectifier diode replacement circuit having reverse bias cut-off drive includes a rectifier diode circuit and a reverse bias cut-off drive circuit 6; the rectifier diode circuit includes an energy storage capacitor C, a low-voltage clock generator 1, a charge pump circuit 2, a bandgap reference circuit 3, a hysteresis comparator 4, a drive amplifier 5 and a power MOS transistor Q;
the low-voltage clock generator 1 detects voltages at both ends A and K of the rectifier diode circuit and generates a clock signal to drive the charge pump circuit 2;
the charge pump circuit 2 detects voltages at both ends A and K of the rectifier diode circuit, and charges are stored into the energy storage capacitor C after being amplified;
voltages stored on the energy storage capacitor C and a reference voltage output by the bandgap reference circuit 3 are respectively output to the hysteresis comparator 4 so as to be compared; when the voltages stored on the energy storage capacitor 4 are greater than the reference voltage output by the bandgap reference circuit 3, the hysteresis comparator 4 outputs an on signal to be amplified by the drive amplifier 5 and then output to the power MOS transistor Q to drive the power MOS transistor Q to be on; and
the reverse bias cut-off drive circuit 6 detects voltages at both ends A and K of the rectifier diode circuit, when a cathode potential is greater than an anode potential, the reverse bias cut-off drive circuit 6 forms a charge discharge channel at both ends of the energy storage capacitor C so that the energy storage capacitor discharges by means of the reverse bias cut-off drive circuit, and the voltages at both ends of the energy storage capacitor C are rapidly dropped; and when the voltages at both ends of the energy storage capacitor C are lower than an output voltage of the bandgap reference circuit 3 in the rectifier diode circuit, the hysteresis comparator 4 outputs an off signal to cut off the power MOS transistor Q.

In the detailed embodiment, the reverse bias cut-off drive circuit 6 includes a transfer switch transistor M1, a second hysteresis comparator 7 and a discharge switch transistor M2; the discharge switch transistor M2 is connected in parallel with the energy storage capacitor C and is controlled to be on or off by the second hysteresis comparator 7; the transfer switch transistor M1 is connected between the positive input end of the second hysteresis comparator 7 and the cathode of the rectifier diode circuit or between the negative input end of the second hysteresis comparator 7 and the anode of the rectifier diode circuit and is controlled to be on or off by the rectifier diode circuit; and the second hysteresis comparator 7 detects voltages at both ends of the rectifier diode circuit, when a cathode potential of the rectifier diode circuit is greater than an anode potential, the second hysteresis comparator 7 controls the discharge switch transistor M2 to be on so that the energy storage capacitor C discharges by means of the discharge switch transistor M2; and when the voltages at both ends of the energy storage capacitor C are lower than an output voltage of the bandgap reference circuit 3 in the rectifier diode circuit, the rectifier diode circuit outputs a control signal to cut off the power MOS transistor Q.

Further, the transfer switch transistor M1 and the discharge switch transistor M2 are composed of MOSFETs; and a gate of the transfer switch transistor M1 is connected with an output of the drive amplifier 5, a source and drain of the discharge switch transistor M2 are connected in parallel between both ends of the energy storage capacitor C, and a gate of the discharge switch transistor M2 is connected with an output of the second hysteresis comparator 7.

In an embodiment 1 and an embodiment 2, the average forward voltage is only about 150 mV. Therefore, the diode circuit has more obvious advantages than a special semiconductor device. However, if no reverse bias cut-off drive circuits are provided, the problem that rapid cut-off may not be realized during reverse bias may exist, the whole discharge period may be finished only when the voltage on the capacitor is dropped to be lower than a bandgap reference output voltage, and the rectifier diode circuit may enter a reverse bias cut-off state only if a power MOSFET is cut off.

If no reverse bias cut-off drive circuits are provided, the on resistance of the power MOSFET may be calculated to be 10 mΩ according to the the forward voltage drop 80 mV obtained in an on state of the power MOSFET when the current is 8A, and the input capacitance of the gate of the power MOSFET having the magnitude order of 10 mΩ is about several nF, in order to ignore influences of switch charge loss of the power MOSFET to the performance of the circuit, generally, the capacitance value of the energy storage capacitor C should be 100 nF or higher, therefore, both charge and discharge times of the diode circuit are longer, calculated according to an equation that T1/(T1+T2)=10% under the condition that the charge time T1 is equal to 5 ms and T2 is the discharge time, the discharge time is 45 ms, and the average on voltage is 152 mV, if being calculated according to an equation that T1/(T1+T2)=99%, the discharge time is 500 ms, the average on voltage is 87.2 mV, and therefore, it is more obvious to obtain a lower average on voltage if the discharge time is long, and after the diode circuit is converted from the forward bias to the reverse bias in the discharge state, the required cut-off time may be longer. An application of the diode circuit is to be seriously affected by such a problem.

According to the technical solution of the present invention, the voltages at both ends of the diode circuit are actively detected in real time, and a rapid discharge channel is generated when the diode circuit is converted from the forward bias to the reverse bias, so that the discharge period is greatly shortened, and the diode circuit is rapidly cut off.

In an Embodiment 3, a reverse bias cut-off drive circuit of a rectifier diode replacement circuit includes a transfer switch transistor M1, a second hysteresis comparator 7 and a discharge switch transistor M2; the discharge switch transistor M2 is connected in parallel with the energy storage capacitor C in the rectifier diode replacement circuit and is controlled to be on or off by the second hysteresis comparator 7; the transfer switch transistor M1 is connected between the positive input end of the second hysteresis comparator 7 and the cathode of the rectifier diode replacement circuit, or the transfer switch transistor M1 is connected between the negative input end of the second hysteresis comparator 7 and the anode of the rectifier diode replacement circuit, the second hysteresis comparator 7 detects voltages at both ends of the rectifier diode replacement circuit, when a cathode potential of the rectifier diode replacement circuit is greater than an anode potential, the second hysteresis comparator 7 controls the discharge switch transistor M2 to be on so that the energy storage capacitor C discharges by means of the discharge switch transistor M2; and when the voltages at both ends of the energy storage capacitor C are lower than an output voltage of the bandgap reference circuit 3 in the rectifier diode replacement circuit, the rectifier diode replacement circuit outputs a control signal to cut off the power MOS transistor Q.

In the detailed embodiment, the transfer switch transistor M1 and the discharge switch transistor M2 are composed of MOSFETs; and a gate of the transfer switch transistor M1 is connected with an output of the drive amplifier 5, a source and drain of the discharge switch transistor M2 are connected in parallel between both ends of the energy storage capacitor C, and a gate of the discharge switch transistor M2 is connected with an output of the second hysteresis comparator 7. In an Embodiment 4, a reverse bias cut-off drive circuit of a rectifier diode replacement circuit includes a transfer switch transistor M1, a second hysteresis comparator 7 and a discharge switch transistor M2; the discharge switch transistor M2 is connected in parallel between the gate of the power MOS transistor Q and a negative end of the energy storage capacitor C in the rectifier diode replacement circuit and is controlled to be on or off by the second hysteresis comparator 7; the transfer switch transistor M1 is connected between the positive input end of the second hysteresis comparator 7 and the cathode of the rectifier diode replacement circuit, or the transfer switch transistor M1 is connected between the negative input end of the second hysteresis comparator 7 and the anode of the rectifier diode replacement circuit, the second hysteresis comparator 7 detects voltages at both ends of the rectifier diode replacement circuit, when a cathode potential of the rectifier diode replacement circuit is greater than an anode potential, the second hysteresis comparator 7 controls the discharge switch transistor M2 to be on to form a charge discharge channel at the gate of the power MOS transistor Q, so that the power MOS transistor Q is cut off; and when the voltages at both ends of the energy storage capacitor C are lower than an output voltage of the bandgap reference circuit 3 in the rectifier diode replacement circuit, the rectifier diode replacement circuit outputs a control signal to cut off the power MOS transistor Q.

In the detailed embodiment, the transfer switch transistor M1 and the discharge switch transistor M2 are composed of MOSFETs; and a gate of the transfer switch transistor M1 is connected with an output of the drive amplifier 5, a source and drain of the discharge switch transistor M2 are connected in parallel between a gate of the power MOS transistor Q and a negative end of the energy storage capacitor C, and a gate of the discharge switch transistor M2 is connected with an output of the second hysteresis comparator 7.

The detailed embodiments of the present invention are described in detail above, however, the content protected by the present invention is not merely limited within the range of the detailed description.

## Claims

1. A rectifier diode replacement circuit having an anode end and a cathode end, comprising a rectifier diode circuit and a reverse bias cut-off drive circuit; the rectifier diode circuit comprises an energy storage capacitor (C), a low-voltage clock generator (1), a charge pump circuit (2), a bandgap reference circuit (3), a hysteresis comparator (4), a drive amplifier (5) and a power MOS transistor (Q);
the low-voltage clock generator (1) is connected with both ends of the rectifier diode replacement circuit and adapted for detecting voltages at both ends of the rectifier diode replacement circuit and generating a clock signal to drive the charge pump circuit (2);
the charge pump circuit (2) is connected with the low-voltage clock generator (1), and the hysteresis comparator (4), and adapted for detecting voltages at both ends of the rectifier diode replacement circuit, and adapted for storing charges into the energy storage capacitor (C) after being amplified;
the rectifier diode circuit is adapted for outputting voltages stored on the energy storage capacitor (C) and a reference voltage output by the bandgap reference circuit (3), respectively, to the hysteresis comparator (4) so as to be compared;
the hysteresis comparator (4) is connected with the drive amplifier (5), and adapted for outputting an on signal to be amplified by the drive amplifier (5), when the voltages stored on the energy storage capacitor (4) are greater than the reference voltage output by the bandgap reference circuit (3);
the drive amplifier (5) is connected with the gate of the power MOS transistor (Q) and adapted for then outputing the amplified signal to the power MOS transistor (Q) to drive the power MOS transistor (Q) to be on wherein the source of the power MOS transistor (Q) is connected to the anode end of the rectifier diode replacement circuit and the drain of the power MOS transistor (Q) is connected to the cathode end of the rectifier diode replacement circuit;
**characterized in that** the reverse bias cut-off drive circuit (6) is connected with both ends of the rectifier diode replacement circuit, and adapted for detecting the voltages at both ends of the rectifier diode replacement circuit, and for forming a charge discharge channel at a gate of the power MOS transistor (Q) to cut off the power MOS transistor (Q), when a cathode potential is greater than an anode potential.

2. A rectifier diode replacement circuit having an anode end and a cathode end, comprising a rectifier diode circuit and a reverse bias cut-off drive circuit; the rectifier diode circuit comprises an energy storage capacitor (C), a low-voltage clock generator (1), a charge pump circuit (2), a bandgap reference circuit (3), a hysteresis comparator (4), a drive amplifier (5) and a power MOS transistor (Q);
the low-voltage clock generator (1) is connected with both ends of the rectifier diode replacement circuit and adapted for detecting voltages at both ends of the rectifier diode replacement circuit and generating a clock signal to drive the charge pump circuit (2);
the charge pump circuit (2) is connected with the low-voltage clock generator (1), and the hysteresis comparator (4), and adapted for detecting voltages at both ends of the rectifier diode replacement circuit, and adapted for storing charges into the energy storage capacitor (C) after being amplified;
the rectifier diode circuit is adapted for outputting voltages stored on the energy storage capacitor (C) and a reference voltage output by the bandgap reference circuit (3), respectively, to the hysteresis comparator (4) so as to be compared;
the hysteresis comparator (4) is connected with the drive amplifier (5), and adapted for outputting an on signal to be amplified by the drive amplifier (5), when the voltages stored on the energy storage capacitor (4) are greater than the reference voltage output by the bandgap reference circuit (3);
the drive amplifier (5) is connected with the gate of the power MOS transistor (Q) and adapted for then outputing the amplified signal to the power MOS transistor (Q) to drive the power MOS transistor (Q) to be on;
wherein the source of the power MOS transistor (Q) is connected to the anode end of the rectifier diode replacement circuit and the drain of the power MOS transistor (Q) is connected to the cathode end of the rectifier diode replacement circuit; wherein the reverse bias cut-off drive circuit (6) is connected with both ends of the rectifier diode replacement circuit and is adapted for forming a charge discharge channel at both ends of the energy storage capacitor (C) so that the energy storage capacitor (C) discharges by means of the reverse bias cut-off drive circuit (6) when a cathode potential is greater than an anode potential and the hysteresis comparator (4) is adapted for outputting an off signal to cut off the power MOS transistor (Q), when the voltages at both ends of the energy storage capacitor (C) are lower than an output voltage of the bandgap reference circuit (3) in the rectifier diode circuit.

3. The rectifier diode replacement circuit of claim 2, **characterized in that** the reverse bias cut-off drive circuit (6) comprises a transfer switch transistor (M1), a second hysteresis comparator (7) and a discharge switch transistor (M2); the discharge switch transistor (M2) is connected in parallel with the energy storage capacitor (C) and is controlled to be on or off by the second hysteresis comparator (7), and the transfer switch transistor (M1) is connected between the positive input end of the second hysteresis comparator (7) and the cathode (K) of the rectifier diode replacement circuit or between the negative input end of the second hysteresis comparator (7) and the anode (A) of the rectifier diode replacement circuit; the transfer switch transistor (M1) is adapted to be controlled to be on or off by the rectifier diode circuit; and the second hysteresis comparator (7) is connected with both ends of the rectifier diode replacement circuit, and adapted for detecting voltages at both ends of the rectifier diode replacement circuit; wherein, when a cathode potential of the rectifier diode replacement circuit is greater than an anode potential, the second hysteresis comparator (7) is adapted for controlling the discharge switch transistor (M2) to be on so that the energy storage capacitor (C) discharges by means of the discharge switch transistor; and when the voltages at both ends of the energy storage capacitor (C) are lower than an output voltage of the bandgap reference circuit (3) in the rectifier diode circuit, the rectifier diode circuit is adapted for outputting a control signal to cut off the power MOS transistor (Q).

4. The rectifier diode replacement circuit of claim 1, **characterized in that** the reverse bias cut-off drive circuit comprises a transfer switch transistor (M1), a second hysteresis comparator (7) and a discharge switch transistor (M2); the discharge switch transistor (M2) is connected in parallel between a gate of the power MOS transistor (Q) and a negative end of the energy storage capacitor (C) and is controlled to be on or off by the second hysteresis comparator (7), and the transfer switch transistor (M1) is connected between the positive input end of the second hysteresis comparator (7) and the cathode (K) of the rectifier diode replacement circuit or between the negative input end of the second hysteresis comparator (7) and the anode (A) of the rectifier diode replacement circuit; the transfer switch transistor (M1) is adapted to be controlled to be on or off by the rectifier diode circuit; the second hysteresis comparator (7) is adapted for detecting voltages at both ends of the rectifier diode circuit, and when a cathode potential of the rectifier diode replacement circuit is greater than an anode potential, the second hysteresis comparator (7) controls the discharge switch transistor (M2) to be on to form a charge discharge channel at the gate (QG) of the power MOS transistor (Q), so that the power MOS transistor (Q) is cut off.

5. The rectifier diode replacement circuit of claim 3, **characterized in that** the transfer switch transistor (M1) and the discharge switch transistor (M2) are composed of MOSFETs; and a gate of the transfer switch transistor (M1) is connected with an output of the drive amplifier (5), a source and drain of the discharge switch transistor (M2) are connected in parallel to both ends of the energy storage capacitor (C), and a gate of the discharge switch transistor (M2) is connected with an output of the second hysteresis comparator (7).

6. The rectifier diode replacement circuit of claim 4, **characterized in that** the transfer switch transistor (M1) and the discharge switch transistor (M2) are composed of MOSFETs; and a gate of the transfer switch transistor (M1) is connected with an output of the drive amplifier (5), a source and drain of the discharge switch transistor (M2) are connected in parallel between a gate (QG) of the power MOS transistor (Q) and a negative end of the energy storage capacitor (C), and a gate of the discharge switch transistor (M2) is connected with an output of the second hysteresis comparator (7).

## Patentansprüche

1. Gleichrichterdioden-Ersatzschaltung mit einem Anodenende und einem Kathodenende, die eine Gleichrichterdiodenschaltung und eine Treiberschaltung mit Sperrvorspannungsabschaltung umfaßt; die Gleichrichterdiodenschaltung umfaßt einen Energiespeicherkondensator (C), einen Niederspannungs-Taktgenerator (1), eine Ladungspumpenschaltung (2), eine Bandlücken-Referenzschaltung (3), einen Hysteresekomparator (4), einen Treiberverstärker (5) und einen Leistungs-MOS-Transistor (Q);
der Niederspannungs-Taktgenerator (1) ist mit beiden Enden der Gleichrichterdioden-Ersatzschaltung verbunden und zum Erfassen von Spannungen an beiden Enden der Gleichrichterdioden-Ersatzschaltung und zum Erzeugen eines Taktsignals zum Treiben der Ladungspumpenschaltung (2) ausgelegt;
die Ladungspumpenschaltung (2) ist mit dem Niederspannungs-Taktgenerator (1) und dem Hysteresekomparator (4) verbunden und zum Detektieren von Spannungen an beiden Enden der Gleichrichterdioden-Ersatzschaltung und zum Speichern von Ladungen in den Energiespeicherkondensator (C) nach der Verstärkung ausgelegt;
die Gleichrichterdiodenschaltung ist zum Ausgeben von Spannungen, die an dem Energiespeicherkondensator (C) gespeichert sind, bzw. einer Referenzspannung, die von der Bandlücken-Referenzschaltung (3) ausgegeben wird, an den Hysteresekomparator (4), um verglichen zu werden, ausgelegt;
der Hysteresekomparator (4) ist mit dem Treiberverstärker (5) verbunden und zur Ausgabe eines von dem Treiberverstärker (5) zu verstärkenden Ein-Signals ausgelegt, wenn die in dem Energiespeicherkondensator (4) gespeicherten Spannungen größer als die von der Bandlücken-Referenzschaltung (3) ausgegebene Referenzspannung sind;
der Treiberverstärker (5) ist mit der Steuerelektrode des Leistungs-MOS-Transistors (Q) verbunden und dafür ausgelegt, dann das verstärkte Signal an den Leistungs-MOS-Transistor (Q) auszugeben, um den Leistungs-MOS-Transistor (Q) so anzusteuern, dass er eingeschaltet ist, wobei die Source des Leistungs-MOS-Transistors (Q) mit dem Anodenende der Gleichrichterdioden-Ersatzschaltung verbunden ist und den Drain des Leistungs-MOS-Transistors (Q) mit dem Kathodenende der Gleichrichterdioden-Ersatzschaltung verbunden ist;
**dadurch gekennzeichnet, dass**
die Sperrvorspannungs-Abschalt-Antriebsschaltung (6) mit beiden Enden der Gleichrichterdioden-Ersatzschaltung verbunden ist und zum Erfassen der Spannungen an beiden Enden der Gleichrichterdioden-Ersatzschaltung und zum Bilden eines Ladungsentladungskanals an einer Steuerelektrode des Leistungs-MOS-Transistors (Q) ausgelegt ist, um den Leistungs-MOS-Transistor (Q) zu sperren, wenn ein Kathodenpotential größer als ein Anodenpotential ist.

2. Gleichrichterdioden-Ersatzschaltung mit einem Anodenende und einem Kathodenende, die eine Gleichrichterdiodenschaltung und eine Treiberschaltung mit Sperrvorspannungsabschaltung umfaßt; die Gleichrichterdiodenschaltung umfaßt einen Energiespeicherkondensator (C), einen Niederspannungs-Taktgenerator (1), eine Ladungspumpenschaltung (2), eine Bandlücken-Referenzschaltung (3), einen Hysteresekomparator (4), einen Treiberverstärker (5) und einen Leistungs-MOS-Transistor (Q);
der Niederspannungs-Taktgenerator (1) ist mit beiden Enden der Gleichrichterdioden-Ersatzschaltung verbunden und zum Erfassen von Spannungen an beiden Enden der Gleichrichterdioden-Ersatzschaltung und zum Erzeugen eines Taktsignals zum Treiben der Ladungspumpenschaltung (2) ausgelegt;
die Ladungspumpenschaltung (2) ist mit dem Niederspannungs-Taktgenerator (1) und dem Hysteresekomparator (4) verbunden und zum Detektieren von Spannungen an beiden Enden der Gleichrichterdioden-Ersatzschaltung und zum Speichern von Ladungen in den Energiespeicherkondensator (C) nach der Verstärkung ausgelegt;
die Gleichrichterdiodenschaltung ist zum Ausgeben von Spannungen, die an dem Energiespeicherkondensator (C) gespeichert sind, bzw. einer Referenzspannung, die von der Bandlücken-Referenzschaltung (3) ausgegeben wird, an den Hysteresekomparator (4) ausgelegt, um verglichen zu werden;
der Hysteresekomparator (4) ist mit dem Treiberverstärker (5) verbunden und zur Ausgabe eines durch den Treiberverstärker (5) zu verstärkenden Ein-Signals ausgelegt, wenn die in dem Energiespeicherkondensator (4) gespeicherten Spannungen größer als die von der Bandlücken-Referenzschaltung (3) ausgegebene Referenzspannung sind;
der Treiberverstärker (5) ist mit der Steuerelektrode eines Leistungs-MOS-Transistors (Q) verbunden und so ausgebildet, dass er dann das verstärkte Signal an den Leistungs-MOS-Transistor (Q) ausgibt, um den Leistungs-MOS-Transistor (Q) so anzusteuern, dass er eingeschaltet ist;
wobei die Source des Leistungs-MOS-Transistors (Q) mit dem Anodenende der Gleichrichterdioden-Ersatzschaltung verbunden ist und der Drain des Leistungs-MOS-Transistors (Q) mit dem Kathodenende der Gleichrichterdioden-Ersatzschaltung verbunden ist; wobei die Sperrvorspannungs-Abschalt-Antriebsschaltung (6) mit beiden Enden der Gleichrichterdioden-Ersatzschaltung verbunden ist und so ausgebildet ist, dass sie einen Ladungsentladungskanal an beiden Enden des Energiespeicherkondensators (C) bildet, so dass der Energiespeicherkondensator (C) mittels der Sperrvorspannungs-Abschalt-Antriebsschaltung (6) entladen wird, wenn ein Kathodenpotential größer als ein Anodenpotential ist, und der Hysteresekomparator (4) so ausgebildet ist, dass er ein Sperrsignal ausgibt, um den Leistungs-MOS-Transistor (Q) abzuschalten, wenn die Spannungen an beiden Enden des Energiespeicherkondensators (C) niedriger sind als eine Ausgangsspannung der Bandlücken-Referenzschaltung (3) in der Gleichrichterdiodenschaltung.

3. Gleichrichterdioden-Ersatzschaltung nach Anspruch 2, **dadurch gekennzeichnet, daß** die Sperrvorspannungs-Abschalt-Antriebsschaltung (6) einen Transferschalttransistor (M1), einen zweiten Hysteresekomparator (7) und einen Entladeschalttransistor (M2) umfaßt; der Entladeschalttransistor (M2) parallel zu dem Energiespeicherkondensator (C) geschaltet ist und durch den zweiten Hysteresekomparator (7) ein- oder ausgeschaltet wird, und der Transferschalttransistor (M1) zwischen das positive Eingangsende des zweiten Hysteresekomparators (7) und die Kathode (K) der Gleichrichterdioden-Ersatzschaltung oder zwischen das negative Eingangsende des zweiten Hysteresekomparators (7) und die Anode (A) der Gleichrichterdioden-Ersatzschaltung geschaltet ist; der Transferschalttransistor (M1) so ausgelegt ist, dass er durch die Gleichrichterdiodenschaltung ein- oder ausgeschaltet wird; und der zweite Hysteresekomparator (7) mit beiden Enden der Gleichrichterdioden-Ersatzschaltung verbunden ist und so ausgelegt ist, dass er Spannungen an beiden Enden der Gleichrichterdioden-Ersatzschaltung erfasst;
wobei dann, wenn ein Kathodenpotential der Gleichrichterdioden-Ersatzschaltung größer als ein Anodenpotential ist, der zweite Hysteresekomparator (7) so ausgebildet ist, daß er den Entladeschalttransistor (M2) so steuert, daß er eingeschaltet ist, so daß sich der Energiespeicherkondensator (C) mittels des Entladeschalttransistors entlädt; und wenn die Spannungen an beiden Enden des Energiespeicherkondensators (C) niedriger sind als eine Ausgangsspannung der Bandlücken-Referenzschaltung (3) in der Gleichrichterdiodenschaltung, ist die Gleichrichterdiodenschaltung zur Ausgabe eines Steuersignals zum Abschalten des Leistungs-MOS-Transistors (Q) ausgelegt.

4. Gleichrichterdioden-Ersatzschaltung nach Anspruch 1, **dadurch gekennzeichnet, daß** die Steuerschaltung zur Sperrung der Sperrvorspannung einen Transferschalttransistor (M1), einen zweiten Hysteresekomparator (7) und einen Entladeschalttransistor (M2) umfaßt; der Entladeschalttransistor (M2) zwischen einer Steuerelektrode des Leistungs-MOS-Transistors (Q) und einem negativen Ende des Energiespeicherkondensators (C) parallelgeschaltet ist und durch den zweiten Hysteresekomparator (7) ein- oder ausgeschaltet wird, und der Transferschalttransistor (M1) zwischen dem positiven Eingangsende des zweiten Hysteresekomparators (7) und der Kathode (K) der Gleichrichterdioden-Ersatzschaltung oder zwischen dem negativen Eingangsende des zweiten Hysteresekomparators (7) und der Anode (A) der Gleichrichterdioden-Ersatzschaltung angeschlossen ist; der Transferschalttransistor (M1) so ausgebildet ist, daß er durch die Gleichrichterdiodenschaltung ein- oder ausgeschaltet werden kann; der zweite Hysterese-Komparator (7) so ausgelegt ist, dass er Spannungen an beiden Enden der Gleichrichterdiodenschaltung erfasst, und wenn ein Kathodenpotential der Gleichrichterdioden-Ersatzschaltung größer als ein Anodenpotential ist, steuert der zweite Hysterese-Komparator (7) den Entladeschalttransistor (M2) so, dass er eingeschaltet ist, um einen Ladungsentladungskanal an der Steuerelektrode (QG) des Leistungs-MOS-Transistors (Q) zu bilden, so dass der Leistungs-MOS-Transistor (Q) abgeschaltet wird.

5. Gleichrichterdioden-Ersatzschaltung nach Anspruch 3, **dadurch gekennzeichnet, daß** der Transferschalttransistor (M1) und der Entladeschalttransistor (M2) aus MOSFETs zusammengesetzt sind; und eine Steuerelektrode des Transferschalttransistors (M1) mit einem Ausgang des Treiberverstärker (5) verbunden ist, eine Source und einen Drain des Entladeschalttransistors (M2) parallel zu beiden Enden des Energiespeicherkondensators (C) geschaltet sind, und eine Steuerelektrode des Entladeschalttransistors (M2) mit einem Ausgang des zweiten Hysteresekomparators (7) verbunden ist.

6. Gleichrichterdioden-Ersatzschaltung nach Anspruch 4, **dadurch gekennzeichnet, daß** der Transferschalttransistor (M1) und der Entladeschalttransistor (M2) aus MOSFETs zusammengesetzt sind; und eine Steuerelektrode des Transferschalttransistors (M1) mit einem Ausgang des Treiberverstärker (5) verbunden ist, eine Source und ein Drain des Entladeschalttransistors (M2) zwischen einer Steuerelektrode (QG) des Leistungs-MOS-Transistors (Q) und einem negativen Ende des Energiespeicherkondensators (C) parallel geschaltet sind, und eine Steuerelektrode des Entladeschalttransistors (M2) mit einem Ausgang des zweiten Hysteresekomparators (7) verbunden ist.

## Revendications

1. Circuit de remplacement de diode de redresseur ayant une extrémité d'anode et une extrémité de cathode, comprenant un circuit de diode de redresseur et un circuit de commande de coupure de polarisation inverse; le circuit de diode de redresseur comprend un condensateur de stockage d'énergie (C), un générateur d'horloge basse tension (1), un circuit de pompe de charge (2), un circuit de référence de bande interdite (3), un comparateur à hystérésis (4), un amplificateur d'attaque (5) et un transistor MOS de puissance (Q) ; le générateur d'horloge basse tension (1) est connecté aux deux extrémités du circuit de remplacement de diode de redresseur et adapté pour détecter des tensions aux deux extrémités du circuit de remplacement de diode de redresseur et générer un signal d'horloge pour entraîner le circuit de pompe de charge (2);
le circuit de pompe de charge (2) est connecté au générateur d'horloge basse tension (1), au comparateur à hystérésis (4), et adapté pour détecter des tensions aux deux extrémités du circuit de remplacement de diode de redresseur, et adapté pour stocker des charges dans le condensateur de stockage d'énergie (C) après avoir été amplifié;
le circuit de diode de redresseur est adapté pour délivrer des tensions stockées sur le condensateur de stockage d'énergie (C) et une tension de référence délivrée par le circuit de référence de bande interdite (3), respectivement, au comparateur à hystérésis (4) afin d'être comparées;
le comparateur à hystérésis (4) est connecté à l'amplificateur d'attaque (5) et adapté pour émettre un signal de mise sous tension à amplifier par l'amplificateur d'attaque (5), lorsque les tensions stockées sur le condensateur de stockage d'énergie (4) sont supérieures à la tension de référence délivrée par le circuit de référence de bande interdite (3); l'amplificateur d'attaque (5) est connecté à la grille du transistor MOS de puissance (Q) et adapté pour ensuite émettre le signal amplifié vers le transistor MOS de puissance (Q) pour entraîner le transistor MOS de puissance (Q) à être mis sous tension, dans lequel la source du transistor MOS de puissance (Q) est connectée à l'extrémité d'anode du circuit de remplacement de diode de redresseur et le drain du transistor MOS de puissance (Q) est connecté à l'extrémité de la cathode du circuit de remplacement de la diode de redresseur;
**caractérisé en ce que** le circuit de commande de coupure de polarisation inverse (6) est connecté aux deux extrémités du circuit de remplacement de diode de redresseur, et adapté pour détecter les tensions aux deux extrémités du circuit de remplacement de diode de redresseur, et pour former un canal de décharge de charge au niveau d'une grille du transistor MOS de puissance (Q) pour couper le transistor MOS de puissance (Q), lorsqu'un potentiel de cathode est supérieur à un potentiel d'anode.

2. Circuit de remplacement de diode de redresseur ayant une extrémité d'anode et une extrémité de cathode, comprenant un circuit de diode de redresseur et un circuit de commande de coupure de polarisation inverse; le circuit de diode de redresseur comprend un condensateur de stockage d'énergie (C), un générateur d'horloge basse tension (1), un circuit de pompe de charge (2), un circuit de référence de bande interdite (3), un comparateur à hystérésis (4), un amplificateur d'entraînement (5) et un transistor MOS de puissance (Q) ;
le générateur d'horloge basse tension (1) est connecté aux deux extrémités de la diode du circuit de remplacement de diode de redresseur et adapté pour détecter des tensions aux deux extrémités du circuit de remplacement de diode de redresseur et générer un signal d'horloge pour entraîner le circuit de pompe de charge (2);
le circuit de pompe de charge (2) est connecté au générateur d'horloge basse tension (1), au comparateur d'hystérésis (4), et adapté pour détecter les tensions aux deux extrémités du circuit de remplacement de diode de redresseur, et adapté pour stocker des charges dans le condensateur de stockage d'énergie (C) après avoir été amplifié;
le circuit de diode de redresseur est adapté pour délivrer des tensions stockées sur le condensateur de stockage d'énergie (C) et une tension de référence délivrée par le circuit de référence de bande interdite (3), respectivement, au comparateur à hystérésis (4) afin d'être comparées;
le comparateur à hystérésis (4) est connecté à l'amplificateur d'attaque (5) et adapté pour émettre un signal de marche à amplifier par l'amplificateur d'attaque (5), lorsque les tensions stockées sur le condensateur de stockage d'énergie (4) sont supérieures à la tension de référence délivrée par le circuit de référence de bande interdite (3); l'amplificateur d'attaque (5) est connecté à la grille du transistor MOS de puissance (Q) et adapté pour délivrer ensuite le signal amplifié au transistor MOS de puissance (Q) pour entraîner le transistor MOS de puissance (Q) à être mis sous tension;
dans lequel la source du transistor MOS de puissance (Q) est connectée à l'extrémité d'anode du circuit de remplacement de diode de redresseur et le drain du transistor MOS de puissance (Q) est connecté à l'extrémité de cathode du circuit de remplacement de diode de redresseur;
dans lequel le circuit de commande de coupure de polarisation inverse (6) est connecté aux deux extrémités du circuit de remplacement de la diode de redresseur et est adapté pour former un canal de décharge de charge aux deux extrémités du condensateur de stockage d'énergie (C) de sorte que le condensateur de stockage d'énergie (C) se décharge au moyen du circuit de commande de coupure de polarisation inverse (6) lorsqu'un potentiel de cathode est supérieur à un potentiel d'anode et que le comparateur à hystérésis (4) est adapté pour émettre un signal bloqué pour couper le transistor MOS de puissance (Q), lorsque les tensions aux deux extrémités du condensateur de stockage d'énergie (C) sont inférieures à une tension de sortie du circuit de référence de bande interdite (3) dans le circuit de diode de redresseur.

3. Circuit de remplacement de diode de redresseur selon la revendication 2, **caractérisé en ce que** le circuit de commande de coupure de polarisation inverse (6) comprend un transistor de commutation de transfert (M1), un deuxième comparateur à hystérésis (7) et un transistor de commutation de décharge (M2);
le transistor de commutation de décharge (M2) est connecté en parallèle avec le condensateur de stockage d'énergie (C) et est commandé pour être mis sous tension ou hors tension par le deuxième comparateur à hystérésis (7), et le transistor de commutation de transfert (M1) est connecté entre l'extrémité d'entrée positive du deuxième comparateur à hystérésis (7) et la cathode (K) du circuit de remplacement de diode de redresseur ou entre l'extrémité d'entrée négative du deuxième comparateur d'hystérésis (7) et l'anode (A) du circuit de remplacement de diode de redresseur; le transistor de commutation de transfert (M1) est adapté pour être commandé pour être mis sous tension ou hors tension par le circuit de diode de redresseur; et
le deuxième comparateur à hystérésis (7) est connecté aux deux extrémités du circuit de remplacement de diode de redresseur, et adapté pour détecter des tensions aux deux extrémités du circuit de remplacement de diode de redresseur;
dans lequel, lorsqu'un potentiel de cathode du circuit de remplacement de diode de redresseur est supérieur à un potentiel d'anode, le deuxième comparateur à hystérésis (7) est adapté pour commander le transistor de commutation de décharge (M2) afin qu'il soit conducteur de sorte que le condensateur de stockage d'énergie (C) se décharge au moyen du transistor de commutation de décharge; et lorsque les tensions aux deux extrémités du condensateur de stockage d'énergie (C) sont inférieures à une tension de sortie du circuit de référence de bande interdite (3) dans le circuit de diode de redresseur, le circuit de diode de redresseur est adapté pour émettre un signal de commande pour couper le transistor MOS de puissance (Q) .

4. Circuit de remplacement de diode de redresseur selon la revendication 1, **caractérisé en ce que** le circuit de commande de coupure de polarisation inverse comprend un transistor de commutation de transfert (M1), un deuxième comparateur à hystérésis (7) et un transistor de commutation de décharge (M2);
le transistor de commutation de décharge (M2) est connecté en parallèle entre une grille du transistor MOS de puissance (Q) et une extrémité négative du condensateur de stockage d'énergie (C) et est commandé pour être mis sous tension ou hors tension par le deuxième comparateur à hystérésis (7) et le transistor de commutation de transfert (M1) est connecté entre l'extrémité d'entrée positive du deuxième comparateur à hystérésis (7) et la cathode (K) du circuit de remplacement de diode de redresseur ou entre l'extrémité d'entrée négative du deuxième comparateur d'hystérésis (7) et l'anode (A) du circuit de remplacement de diode de redresseur;
le transistor de commutation de transfert (M1) est adapté pour être commandé pour être mis sous tension ou hors tension par le circuit de diode de redresseur; le deuxième comparateur à hystérésis (7) est adapté pour détecter des tensions aux deux extrémités du circuit de diode de redresseur, et lorsqu'un potentiel de cathode du circuit de remplacement de diode de redresseur est supérieur à un potentiel d'anode, le second comparateur à hystérésis (7) commande le transistor de commutation de décharge (M2) afin d'être conducteur pour former un canal de décharge de charge au niveau de la grille (QG) du transistor MOS de puissance (Q), de sorte que le transistor MOS de puissance (Q) soit coupé.

5. Circuit de remplacement de diode de redresseur selon la revendication 3, **caractérisé en ce que** le transistor de commutation de transfert (M1) et le transistor de commutation de décharge (M2) sont composés de MOSFET; et une grille du transistor de commutation de transfert (M1) est connectée à une sortie de l'amplificateur d'attaque (5), une source et un drain du transistor de commutation de décharge (M2) sont connectés en parallèle aux deux extrémités du condensateur de stockage d'énergie (C), et une grille du transistor de commutation de décharge (M2) est connectée à une sortie du deuxième comparateur à hystérésis (7).

6. Circuit de remplacement de diode de redresseur selon la revendication 4, **caractérisé en ce que** le transistor de commutation de transfert (M1) et le transistor de commutation de décharge (M2) sont composés de MOSFET; et une grille du transistor de commutation de transfert (M1) est connectée à une sortie de l'amplificateur d'attaque (5), une source et un drain du transistor de commutation de décharge (M2) sont connectés en parallèle entre une grille (QG) du transistor MOS de puissance (Q) et une extrémité négative du condensateur de stockage d'énergie (C), et une grille du transistor de commutation de décharge (M2) est connectée à une sortie du deuxième comparateur à hystérésis (7).
